# EUROPEAN PATENT SPECIFICATION

(11) **EP 2 729 964 B1**
(45) Date of publication and mention of the grant of the patent: **20.03.2019**
(21) Application number: 11729314.2
(22) Date of filing: 05.07.2011
(51) Int. Cl.: H01L 23/02, H01L 25/07, H01L 25/11, H01L 23/051

(54) **SHORT-CIRCUIT FAILURE MODE WITH MULTIPLE DEVICE BREAKDOWN**
KURZSCHLUSSFEHLERMODUS MIT MEHRFACHGERÄTEAUSFALL
MODE DE DÉFAILLANCE PAR COURT-CIRCUIT À PANNE DE MULTIPLES DISPOSITIFS

(43) Date of publication of application: 14.05.2014
(73) Proprietor: ABB Schweiz AG, 5400 Baden (CH)
(72) Inventor: WILDNER, Franz, 5064 Wittnau (CH); STRASSEL, Thorsten, 5243 Mülligen (CH)
(74) Representative: Ahrengart, Kenneth
(86) International application number: PCT/EP2011/061289
(87) International publication number: WO 2013/004297

(56) References cited:
- EP-A1- 2 330 740

## Description

### Field of the invention

The invention relates in general to high voltage direct current (HVDC) power transmission, and more specifically to power semiconductor modules featuring the short-circuit failure mode (SCFM).

The present invention is defined in the claims. Examples disclosed in the present description which do not fall under the scope defined in the claims do not form part of the present invention, even when they are referred to as "embodiments of the invention".

### Background of the invention

In HVDC applications and static var compensators (SVC) utilizing valves, semiconductor modules comprising power semiconductor devices featuring the SCFM are frequently utilized.

Typically, a semiconductor module comprises several power semiconductor devices, in particular insulated bipolar gate transistors (IGBT) and diodes, connected in parallel for sharing the current through the module. A plurality of such modules may be connected in series, often arranged as a stack, in order to achieve a desired voltage rating. The SCFM of the semiconductor devices enables the continued operation of such a stack in case of a failure of one of the semiconductor devices, e.g., due to cosmic radiation. In the event of a failure, an electrically conducting alloy of, e.g., silicon and a metal layer applied to the silicon, is formed by virtue of heat dissipated as a consequence of the failure, thereby short-circuiting the semiconductor device and enabling a continued operation of the stack until the failed module is replaced.

Initially, after the SCFM has formed, the short-circuited device takes over the entire current through the module. Over time neighboring devices may also transition into SCFM, a process which requires the occurrence of a sufficiently high voltage between collector and emitter for the transition to take place.

EP 2 330 740 describes a system where at least two power semiconductor chips are connected in parallel and each comprising a gate terminal for switching the power semiconductor chip in a blocking state by a first gate voltage and for switching the power semiconductor chip in a conducting state by a second gate voltage. The system comprises further a control means adapted for applying the first or the second gate voltage to the gate terminals of the at least two power semiconductor chips. The control means is adapted for applying a third gate voltage to the gate terminal of the at least one remaining power semiconductor chip when a power semiconductor chip fails, where the third gate voltage is higher than the second gate voltage.

### Summary of the invention

It is an object of the present invention to provide a more efficient alternative to the above techniques and prior art.

More specifically, it is an object of the present invention to provide an improved utilization of the SCFM.

These and other objects of the present invention are achieved by means of a circuit having the features defined in independent claim 1, and by means of a method of a power semiconductor module defined in independent claim 9. Embodiments of the invention are characterized by the dependent claims.

According to a first aspect of the invention, a circuit is provided. The circuit comprises a power semiconductor module. The power semiconductor module comprises a plurality of semiconductor devices, a collector terminal, and an emitter terminal. Each semiconductor device comprises a semiconductor die as well as has a collector, an emitter, and a gate. Each semiconductor device is arranged for transitioning into an SCFM in the event of a failure of the semiconductor device. The collector terminal is arranged for collectively connecting the collectors of the plurality of semiconductor devices to external circuit components. The emitter terminal is arranged for collectively connecting the emitters of the plurality of semiconductor devices to external circuit components. The circuit further comprises a high-voltage unit arranged to detect the transitioning of any of the semiconductor devices into SCFM and to supply a high-voltage pulse to the gate of at least one of the other semiconductor devices of the plurality of semiconductor devices. The high-voltage pulse is supplied in response to a failing semiconductor device of the plurality of semiconductor devices transitioning into SCFM and being set to cause an excessive current through the semiconductor die of the at least one of the other semiconductor devices resulting in the transitioning of the device into SCFM.

According to a second aspect of the invention, a method of a power semiconductor module is provided. The power semiconductor module comprises a plurality of semiconductor devices, a collector terminal, and an emitter terminal. Each semiconductor device comprises a semiconductor die as well as has a collector, an emitter, and a gate. Each semiconductor device is arranged for transitioning into an SCFM in the event of a failure of the semiconductor device. The collector terminal is arranged for collectively connecting the collectors of the plurality of semiconductor devices to external circuit components. The emitter terminal is arranged for collectively connecting the emitters of the plurality of semiconductor devices to external circuit components. The method comprises detecting the transitioning of any of the semiconductor devices into SCFM and supplying a high-voltage pulse to the gate of at least one of the other of the plurality of semiconductor devices. The high-voltage pulse is supplied in response to the transitioning of a failing semiconductor device of the plurality of semiconductor devices into SCFM and is set to cause an excessive current through the semiconductor die of the at least one of the other semiconductor devices resulting in the transitioning of the device into SCFM.

In HVDC applications and SVCs, a plurality of semiconductor devices is often combined in order to achieve a desired current and/or voltage rating. Typically, a stack of power semiconductor modules connected in series is utilized in order to achieve a desired voltage rating, wherein each module comprises a plurality of semiconductor devices connected in parallel in order to achieve a desired current rating. By utilizing semiconductor devices featuring SCFM, and by providing for redundancy, the stack as a whole may continue operation even though a single, or even several, of the devices comprised in the stack have failed, e.g., due to cosmic radiation. Redundancy may be provided by utilizing more modules than what is necessary in order to achieve a desired voltage rating. In that way, if one, or several, of the modules are short-circuited due to one, or several, of their respective devices transitioning into SCFM, the remaining modules which are still functioning may share the voltage which is applied over the stack.

For the purpose of describing the present invention, semiconductor devices featuring SCFM have a collector, an emitter, and a gate, and are arranged for transitioning into SCFM in the event of a device failure. For this purpose, the semiconductor die of the device, which may, e.g., be silicon based, is supplied with a metal layer abutting the die. The transitioning of such a device into SCFM is then caused by the heat dissipated from the failure, or, more specifically, from an excessive current flowing as a consequence of the failure, resulting in the formation of an electrically conducting alloy of metal and silicon. The electrically conducting alloy short-circuits the collector, the emitter, and the gate, of the device.

The present invention makes use of an understanding that the reliability of power semiconductor modules, and stacks comprising several of such modules connected in series, may be enhanced by forcing multiple semiconductor devices comprised in a power semiconductor module into SCFM. To this end, a circuit according to an embodiment of the invention, the circuit comprising a power semiconductor module comprising a plurality of semiconductor devices connected in parallel, is arranged for forcing, in the event of a failure of one of the devices, at least one of the other devices, i.e., at least one of the devices which have not failed, into SCFM. This is achieved by supplying a high-voltage pulse to the gate of the at least one of the other devices, resulting in an excessive current through the die, which causes the transitioning of the device into SCFM. The transitioning into SCFM is caused by the heat dissipated by the current passing through the die. Only little energy is required for initiating the transition, whereas the energy needed for the formation of the alloy stems from the collector-emitter current.

Forcing devices connected in parallel to the failed device to transition into SCFM is advantageous in that it leads to an improved current distribution within the module. More specifically, the current through the module is shared by multiple short-circuited devices. In this way, the heat dissipation in the module is reduced, resulting in an enhanced life time and a lowering of the cooling requirements. Moreover, forcing the parallel devices to transition into SCFM is more reliable than relying on an autonomous transitioning of the devices, as the latter requires the occurrence of a sufficiently high voltage between the collector and the emitter.

An embodiment of the present invention is further advantageous in that no power source is needed for maintaining devices which are parallel to the short-circuited device in a switched-on state, as is the case for prior art solutions which strive to achieve current sharing. In such solutions the gate unit is typically configured for maintaining parallel devices in a switched-on state. However, due to the short-circuit, the gate unit cannot drain power from a collector-emitter clamp.

According to an embodiment of the invention, each semiconductor device is either an insulated-gate bipolar transistor, IGBT, or a diode. Typically, a power semiconductor module may comprise a combination of IGBTs and diodes. In general, the invention is not limited to IGBTs and diodes, and embodiments of the invention comprising any other type of switchable high-power semiconductor device may easily be envisaged.

According to an embodiment of the invention, the circuit further comprises a gate unit. The gate unit is arranged for supplying a control voltage to the gates of the plurality of semiconductor devices. The control voltage is supplied during normal operation, i.e., prior to one of the semiconductor devices transitioning into SCFM. The gate unit may, e.g., be integrated with the power semiconductor module or arranged separately from it. Further, the gate unit may also be arranged for supplying a control voltage to multiple modules, e.g., all the series-connected modules comprised in a stack.

According to an embodiment of the invention, the control voltage is supplied simultaneously to the gates of the plurality of semiconductor devices. This may, e.g., be achieved by collectively connecting the gates of the plurality of semiconductor devices comprised in a module to the gate unit. In this case, the gate unit may further be arranged for disconnecting the gate of the failed semiconductor device from the gate unit. The gate is disconnected in the event of a failure of the semiconductor device, before the high-voltage pulse is supplied to the gate of at least one of the other semiconductor devices. This is advantageous since IGBTs connected in parallel to a short-circuited device are blocking, as a consequence of the common gate connection being clamped, through the short-circuited device, to emitter potential. By disconnecting the gate of the short-circuited device, the parallel IGBTs remain operable and may be forced to transition into SCFM by supplying a high-voltage pulse to their gates, thereby inducing an excessive current through the devices which results in the hereinbefore mentioned melting of the die and the metal layer applied to it. If, however, the short-circuited device is a diode, the gate of that diode need not to be disconnected from the gate unit, since the short circuit in this case does not prevent the operation of parallel devices.

According to an embodiment of the invention, the means for supplying a high-voltage pulse is arranged at the gate unit. In other words, the gate unit and the means for supplying a high-voltage pulse are integrated into a single unit. This is advantageous in that a more compact design may be achieved and additional connections between separate devices may be avoided.

According to an embodiment of the invention, the means for disconnecting the gate of the failed semiconductor device from the gate unit is arranged at the gate unit. In other words, the means for disconnecting the gate of the failed semiconductor device from the gate unit and the gate unit are integrated into one unit. This is advantageous in that a more compact design may be achieved and additional connections between separate devices may be avoided. Preferably, the gate unit, the means for supplying a high-voltage pulse, and the means for disconnecting the gate of the failed semiconductor device from the gate unit, are integrated into a single unit. This unit may, e.g., be arranged at the power semiconductor module or separate from the module.

According to an embodiment of the invention, the power semiconductor module is further arranged for supplying high-voltage pulses sequentially, i.e., one at a time, to the gates of the other semiconductor devices. In other words, the high-voltage pulse may be applied only to a single gate at a time, with a subsequent transition of the respective device into SCFM. This may be repeated after a predetermined time period, resulting in the transition of yet another device into SCFM. Alternatively, the repetition may be triggered upon detecting the previous device transitioning into SCFM.

According to an embodiment of the invention, the circuit comprises a plurality of power semiconductor modules. The power semiconductor modules are connected in series. Connecting a plurality of power semiconductor modules in series is advantageous in that a higher voltage rating may be achieved.

Further objectives of, features of, and advantages with, the present invention will become apparent when studying the following detailed disclosure, the drawings and the appended claims. Those skilled in the art realize that different features of the present invention can be combined to create embodiments other than those described in the following.

### Brief description of the drawings

The above, as well as additional objects, features and advantages of the present invention, will be better understood through the following illustrative and non-limiting detailed description of embodiments of the present invention, with reference to the appended drawings, in which:
Fig. 1 is a cross section of a press-pack power semiconductor module, in accordance with an embodiment of the invention.
Fig. 2 is a top view of a power semiconductor module, in accordance with another embodiment of the invention.
Fig. 3 is a cross section of a power semiconductor stack, in accordance with a further embodiment of the invention.

All the figures are schematic, not necessarily to scale, and generally only show parts which are necessary in order to elucidate the invention, wherein other parts may be omitted or merely suggested.

### Detailed description

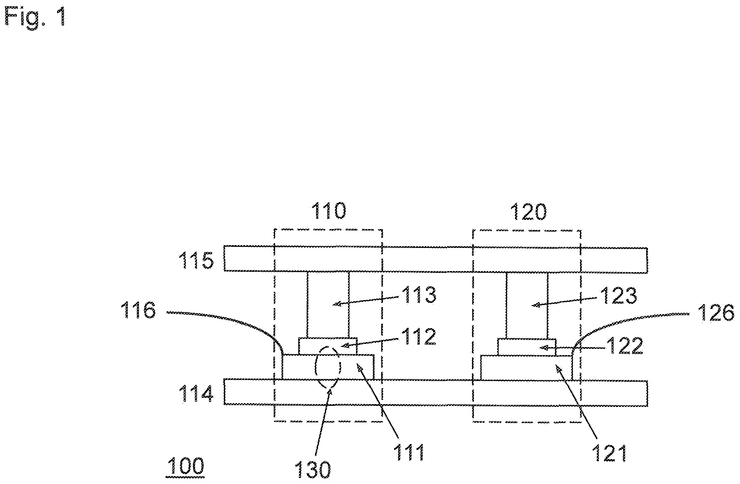

With reference to Fig. 1, a power semiconductor module according to an embodiment of the invention is described. Fig. 1 shows a power semiconductor module 100 in press-pack style, comprising power semiconductor devices 110 and 120. Semiconductor devices 110 and 120 are arranged for transitioning into SCFM in the event of a device failure.

Device 110 comprises a semiconductor die 111, which is arranged for performing the intended function of the device, e.g., that of an IGBT or a diode, a metal layer 112 abutting die 111, an a resilient element 113 being arranged for applying a compressive force to die 111 and metal layer 112. Resilient element 113 may, e.g., be a compressed spring held in place by collector terminal 114 and emitter terminal 115. Resilient element 113 is either electrically conducting or is supplied with an electrically conducting bypass, such that die 111 may be electrically connected to external circuit components via terminals 114 and 115. The gate of die 111 is contacted by means of bond 116. Device 120 is identical to device 110 and comprises a semiconductor die 121, a metal layer 122, a resilient element 123, and a gate bond 126.

In the event of a failure of any of the semiconductor devices 110 or 120 comprised in module 100, the failing device transitions into SCFM. The cause of such a failure may, e.g., be cosmic radiation resulting in an excessive current through the semiconductor die, which current is due to charge carriers which are set free as a consequence of the high-energetic cosmic radiation. The transitioning into SCFM, i.e., the short circuit of die 111, is brought about by heat dissipated as a consequence of the excessive current passing through die 111, resulting in the melting of die 111 and metal layer 112 and the formation of an electrically conducting alloy in the depicted region 130.

In the event of a failure of any of the semiconductor devices comprised in a power semiconductor module according to an embodiment of the invention, e.g., device 110 comprised in module 100 described with reference to Fig. 1, and the subsequent transitioning of that device into SCFM, at least one of the other devices connected in parallel to the short-circuited device, e.g., device 120, is forced to transition into SCFM by applying a high-voltage pulse to the gate of device 120, via gate bond 126. The high-voltage pulse is supplied by means for supplying a high-voltage pulse, which module 100 is arranged with. Alternatively, a gate unit (not shown in Fig. 1), which is utilized for supplying a control voltage to the gates of the power semiconductor devices comprised in a power semiconductor module, or several power semiconductor module, during normal operation, may be arranged for supplying a high-voltage pulse to the gate of device 120. In general, a high-voltage pulse may be supplied to one or more of the devices comprised in the same module as the short-circuited device and connected in parallel to it. In particular, a high-voltage pulse may be supplied to all such devices simultaneously.

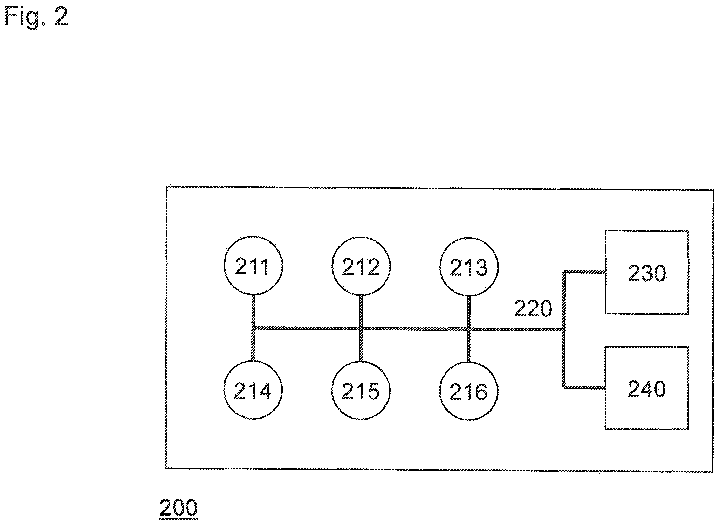

In order to further elucidate the invention, another embodiment of a power semiconductor module is illustrated in Fig. 2. Power semiconductor module 200 comprises six power semiconductor devices 211-216 arranged in a press-pack style, i.e., similar to module 100 described with reference to Fig. 1, between a collector terminal and an emitter terminal. Devices 211-216 may be IGBTs, diodes, or any combination thereof. The gates of devices 211-216 are connected via bonds 220 to gate unit 230 and high-voltage unit 240, respectively. High-voltage unit 240 is arranged for supplying high-voltage pulses to the gate of at least one device 211-216 connected in parallel to a short-circuited device, as was described hereinbefore. In the event of a failure of device 211, and the subsequent transitioning of device 211 into SCFM, high-voltage unit 240 is arranged for supplying a high-voltage pulse to at least one of the remaining devices 212-216. In particular, unit 240 may be arranged for simultaneously supplying a high-voltage pulse to all of the remaining devices 212-216, thereby short-circuiting all devices 211-216 comprised in module 200. Alternatively, high-voltage unit 240 may be arranged for supplying high-voltage pulses to the respective gates of devices 212-216 sequentially, i.e., one at a time. For instance, the next pulse in the sequence may either be supplied after a predetermined time intervall has lapsed since the previous pulse, or in response to detecting that the device which has received the previous high-voltage pulse has started transitioning into SCFM. The high-voltage unit 240 is further arranged for detecting the transitioning of any of the devices 211-216 into SCFM. This may, e.g., be accomplished by detecting a change in gate potential with respect to the emitter and/or collector potential. Further, a failure of a semiconductor device, with an imminent transitioning into SCFM as a consequence, may be detected by monitoring a current, such as the collector-emitter curent, through the device.

Further with reference to Fig. 2, gate unit 230 and high-voltage unit 240 may be arranged separately from module 200, e.g., for the purpose of supplying an entire stack of power semiconductor modules with control voltage and high-voltage pulses, respectively. It will also be appreciated that module 200 may be arranged with switching means (not shown in Fig. 2) being arranged for connecting either gate unit 230 or high-voltage unit 240, i.e., only one of the units at a time, to the gates of devices 211-216. The switching means may further be arranged for disconnecting, in response to any one of the devices 211-216 transitioning into SCFM, gate unit 230 from the gates of devices 211-216 and connecting high-voltage unit 240 to the gates of devices 211-216 instead. In other words, the gates of devices 211-216 are connected to gate unit 230 during normal operation, whereas they are connected to high-voltage unit 240 in the event of a failure of any one of the devices 211-216.

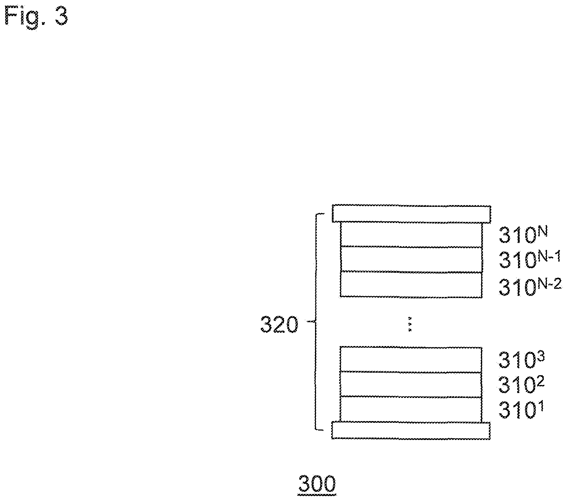

In Fig. 3, a stack according to yet another embodiment of the invention is illustrated. Stack 300 comprises multiple power semiconductor modules 310¹-310^{N} connected in series, such as modules 100 and 200 described with reference to Figs. 1 and 2, respectively. The number of modules 310¹-310^{N} connected in series depends on the desired voltage rating and the desired redundancy of the stack. In the event of a failure in a power semiconductor device comprised in one of the modules 310¹-310^{N} of stack 300, e.g., in module 310², and the subsequent short-circuiting of that device, one or several of the other devices comprised in module 310² and connected in parallel with the short-circuited device are forced into SCFM, as is described hereinbefore. As a consequence, module 310² is short-circuited and the voltage drop over module 310² virtually vanishes. As a result, the remaining modules 310¹ and 310³-310^{N} take over and share the voltage 320 applied over stack 300. Depending on the operating conditions and the redundancy provided, defective modules, or the entire stack, are replaced before a maximum number of redundant modules have failed.

It will be appreciated that the required size of the high-voltage pulse, and its duration, depend on the application at hand, in particular on the design of the power semiconductor device and its die, as well as the gate condition. For instance, for a device with a 2.5 kV rating, a pulse of about 3.3 kV is typically needed in case of gate-on-emitter potential. In the event of a floating gate, i.e., after disconnecting the gate from the gate unit, as described hereinabove, the required pulse is typically about 1.5 kV.

The person skilled in the art realizes that the present invention by no means is limited to the embodiments described above. On the contrary, many modifications and variations are possible within the scope of the appended claims. For instance, one may envisage a gate unit being arranged for supplying a high-voltage pulse to the gate of one of the semiconductor devices of the plurality of semiconductor devices, in response to a failing semiconductor device of another of the plurality of semiconductor devices transitioning into SCFM, in accordance with an embodiment of the invention. Such a gate unit may, e.g., be used to modify existing power semiconductor modules. In other words, an existing power semiconductor module may be supplied with a gate unit which is arranged for performing an embodiment of the second aspect of the invention.

In conclusion, a circuit comprising a power semiconductor module having an improved SCFM is provided. The power semiconductor module comprises at least two semiconductor devices being arranged for transitioning into SCFM in the event of a device failure, a collector terminal for collectively connecting the collectors of the devices, and an emitter terminal for collectively connecting the emitters of the devices. The circuit further comprises means for supplying, in response to one of the semiconductor devices transitioning into SCFM, a high-voltage pulse to the gate of the other semiconductor device, thereby triggering a transitioning of the other device into SCFM. This is advantageous in that it leads to an improved current distribution within the module since the current is shared by more than one short-circuited device. Further, a method of a power semiconductor module is provided.

## Claims

1. A circuit comprising:
a power semiconductor module (100; 200) comprising:
a plurality of semiconductor devices (110, 120; 211-216), each semiconductor device comprising a semiconductor die (111) having a collector, an emitter, and a gate (116, 126; 220), and being arranged for transitioning into a short-circuit failure mode, SCFM, in the event of a failure of the semiconductor device,
a collector terminal (114) being arranged for collectively connecting the collectors of the plurality of semiconductor devices to external circuit components,
an emitter terminal (115) being arranged for collectively connecting the emitters of the plurality of semiconductor devices to external circuit components, and
a high-voltage unit (240) arranged to
detect the transitioning of any of the semiconductor devices into SCFM and
supply, a high-voltage pulse to the gate of at least one of the other semiconductor devices (212-216) of the plurality of semiconductor devices, wherein the high-voltage unit is arranged to supply the high voltage pulse in response to a failing semiconductor device (211) of the plurality of semiconductor devices transitioning into an SCFM,
**characterised in that** said high voltage pulse being set to cause an excessive current through the semiconductor die (111) of the at least one of the other semiconductor devices (212-216) resulting in the transitioning of the device into SCFM.

2. The circuit according to claim 1, wherein each semiconductor device is an insulated-gate bipolar transistor, IGBT.

3. The circuit according to claim 1, further comprising a gate unit (230) arranged to supply, during normal operation, a control voltage to the gates of the plurality of semiconductor devices.

4. The circuit according to claim 3, wherein the gate unit is arranged to supply the control voltage simultaneously to the gates of the plurality of semiconductor devices, the circuit further comprising switching means arranged to disconnect the gate of the failed semiconductor device from the gate unit, said switching means being further arranged to disconnect said gate of the failed semiconductor device before the supply of the high-voltage pulse.

5. The circuit according to claim 3, wherein the high-voltage unit is arranged at the gate unit.

6. The circuit according to claim 4, wherein the switching means is arranged at the gate unit.

7. The circuit according to claim 1, wherein the high voltage unit is arranged to supply high-voltage pulses sequentially, one at a time, to the gates of the other semiconductor devices.

8. The circuit according to any one of the claims 1-7, comprising a plurality of power semiconductor modules (30¹-310^{N}) connected in series.

9. A method of a power semiconductor module (100; 200) comprising:
a plurality of semiconductor devices (110, 120; 211-216), each semiconductor device comprising a semiconductor die (111) having a collector, an emitter, and a gate (116, 126; 220), and being arranged for transitioning into a short-circuit failure mode, SCFM, in the event of a failure of the semiconductor device,
a collector terminal (114) being arranged for collectively connecting the collectors of the plurality of semiconductor devices to external circuit components, and
an emitter terminal (115) being arranged for collectively connecting the emitters of the plurality of semiconductor devices to external circuit components,
wherein the method comprises detecting the transitioning of any of the semiconductor devices into SCFM and supplying a high-voltage pulse to the gate of at least one of the other semiconductor devices (212-216) of the plurality of semiconductor devices, wherein said high voltage pulse is supplied in response to a failing semiconductor device (211) of the plurality of semiconductor devices transitioning into an SCFM **characterised in that** said high voltage pulse is set to cause an excessive current through the semiconductor die (111) of the at least one of the other semiconductor devices (212-216) resulting in the transitioning of the device into SCFM.

10. The method according to claim 9, further comprising disconnecting the gate of the failed semiconductor device from a gate unit (230) before supply of the high-voltage pulse.

11. The method according to claim 9, further comprising sequentially supplying high-voltage pulses, one at a time, to the gates of the other semiconductor devices.

## Patentansprüche

1. Schaltung, umfassend:
ein Leistungshalbleitermodul (100, 200), umfassend:
eine Vielzahl von Halbleitereinrichtungen (110, 120; 211-216), wobei jede Halbleitereinrichtung ein Halbleiter-Die (111) mit einem Kollektor, einem Emitter und einem Gate (116, 126; 220) umfasst und eingerichtet ist, um bei einem Ausfall der Halbleitereinrichtung in einen Kurzschlussausfallbetrieb, SCFM, überzugehen,
einen Kollektoranschluss (114), der eingerichtet ist, um die Kollektoren der Vielzahl von Halbleitereinrichtungen gemeinsam mit externen Schaltungskomponenten zu verbinden,
einen Emitteranschluss (115), der eingerichtet ist, um die Emitter der Vielzahl von Halbleitereinrichtungen gemeinsam mit externen Schaltungskomponenten zu verbinden, und
eine Hochspannungseinheit (240), die eingerichtet ist, um
das Übergehen einer der Halbleitereinrichtungen in den SCFM zu erfassen und
dem Gate mindestens einer der anderen Halbleitereinrichtungen (212-216) der Vielzahl von Halbleitereinrichtungen einen Hochspannungsimpuls zuzuführen,
wobei die Hochspannungseinheit eingerichtet ist, um den Hochspannungsimpuls in Reaktion darauf zuzuführen, dass eine ausfallende Halbleitereinrichtung (211) der Vielzahl von Halbleitereinrichtungen in einen SCFM übergeht,
**dadurch gekennzeichnet, dass** der Hochspannungsimpuls so eingestellt ist, dass er einen Überschussstrom durch das Halbleiter-Die (111) der mindestens einen der anderen Halbleitereinrichtungen (212-216) bewirkt, welcher im Übergehen der Einrichtung in den SCFM resultiert.

2. Schaltung nach Anspruch 1, wobei es sich bei jeder Halbleitereinrichtung um einen Bipolartransistor mit isoliertem Gate, IGBT, handelt.

3. Schaltung nach Anspruch 1, ferner umfassend eine Gateeinheit (230), die eingerichtet ist, um den Gates der Vielzahl von Halbleitereinrichtungen im Normalbetrieb eine Steuerspannung zuzuführen.

4. Schaltung nach Anspruch 3, wobei die Gateeinheit eingerichtet ist, um die Steuerspannung den Gates der Vielzahl von Halbleitereinrichtungen gleichzeitig zuzuführen, wobei die Schaltung ferner Schaltmittel umfasst, die eingerichtet sind, um das Gate der ausgefallenen Halbleitereinrichtung von der Gateeinheit zu trennen, wobei die Schaltmittel ferner eingerichtet sind, um das Gate der ausgefallenen Halbleitereinrichtung vor der Zuführung des Hochspannungsimpulses zu trennen.

5. Schaltung nach Anspruch 3, wobei die Hochspannungseinheit an der Gateeinheit angeordnet ist.

6. Schaltung nach Anspruch 4, wobei das Schaltmittel an der Gateeinheit angeordnet ist.

7. Schaltung nach Anspruch 1, wobei die Hochspannungseinheit eingerichtet ist, um den Gates der anderen Halbleitereinrichtungen einzeln aufeinanderfolgend Hochspannungsimpulse zuzuführen.

8. Schaltung nach einem der Ansprüche 1 bis 7, umfassend eine Vielzahl in Reihe geschalteter Leistungshalbleitermodule (30¹-310^{N}).

9. Verfahren eines Leistungshalbleitermoduls (100; 200), umfassend:
eine Vielzahl von Halbleitereinrichtungen (110, 120; 211-216), wobei jede Halbleitereinrichtung ein Halbleiter-Die (111) mit einem Kollektor, einem Emitter und einem Gate (116, 126; 220) umfasst und eingerichtet ist, um bei einem Ausfall der Halbleitereinrichtung in einen Kurzschlussausfallbetrieb, SCFM, überzugehen,
einen Kollektoranschluss (114), der eingerichtet ist, um die Kollektoren der Vielzahl von Halbleitereinrichtungen gemeinsam mit externen Schaltungskomponenten zu verbinden,
einen Emitteranschluss (115), der eingerichtet ist, um die Emitter der Vielzahl von Halbleitereinrichtungen gemeinsam mit externen Schaltungskomponenten zu verbinden,
wobei das Verfahren ein Erfassen des Übergehens einer der Halbleitereinrichtungen in den SCFM und ein Zuführen eines Hochspannungsimpulses zu dem Gate mindestens einer der anderen Halbleitereinrichtungen (212-216) der Vielzahl von Halbleitereinrichtungen umfasst,
wobei der Hochspannungsimpuls in Reaktion darauf zugeführt wird, dass eine ausfallende Halbleitereinrichtung (211) der Vielzahl von Halbleitereinrichtungen in einen SCFM übergeht,
**dadurch gekennzeichnet, dass** der Hochspannungsimpuls so eingestellt ist, dass er einen Überschussstrom durch das Halbleiter-Die (111) der mindestens einen der anderen Halbleitereinrichtungen (212-216) bewirkt, welcher im Übergehen der Einrichtung in den SCFM resultiert.

10. Verfahren nach Anspruch 9, ferner umfassend ein Trennen des Gates der ausgefallenen Halbleitereinrichtung von einer Gateeinheit (230) vor der Zuführung des Hochspannungsimpulses.

11. Verfahren nach Anspruch 9, ferner umfassend ein aufeinanderfolgend einzeln erfolgendes Zuführen von Hochspannungsimpulsen zu den Gates der anderen Halbleitereinrichtungen.

## Revendications

1. Circuit, comprenant :
un module à semi-conducteur de puissance (100 ; 200) comprenant :
une pluralité de dispositifs à semi-conducteur (110, 120 ; 211-216), chaque dispositif à semi-conducteur comprenant une puce à semi-conducteur (111) dotée d'un collecteur, d'un émetteur et d'une grille (116, 126 ; 220) et étant agencé pour passer dans un mode défaillance court-circuit, noté SCFM, en cas de défaillance du dispositif à semi-conducteur,
une borne collecteur (114) étant agencée pour connecter collectivement les collecteurs de la pluralité de dispositifs à semi-conducteur à des composants de circuit externes,
une borne émetteur (115) étant agencée pour connecter collectivement les émetteurs de la pluralité de dispositifs à semi-conducteur à des composants de circuit externes, et
une unité à haute tension (240) agencée pour détecter le passage de l'un quelconque des dispositifs à semi-conducteur dans le SCFM, et
délivrer une impulsion à haute tension à la grille d'au moins un des autres dispositifs à semi-conducteur (212-216) de la pluralité de dispositifs à semi-conducteur,
l'unité à haute tension étant agencée pour délivrer l'impulsion à haute tension en réponse au passage d'un dispositif à semi-conducteur défaillant (211) de la pluralité de dispositifs à semi-conducteur dans un SCFM,
**caractérisé en ce que** ladite impulsion à haute tension est établie de manière à faire circuler un courant excessif dans la puce à semi-conducteur (111) de l'au moins un des autres dispositifs à semi-conducteur (212-216) pour provoquer le passage du dispositif dans le SCFM.

2. Circuit selon la revendication 1, dans lequel chaque dispositif à semi-conducteur est un transistor bipolaire à grille isolée, noté IGBT.

3. Circuit selon la revendication 1, comprenant en outre une unité à grilles (230) agencée pour délivrer, en fonctionnement normal, une tension de commande aux grilles de la pluralité de dispositifs à semi-conducteur.

4. Circuit selon la revendication 3, dans lequel l'unité à grilles est agencée pour délivrer la tension de commande simultanément aux grilles de la pluralité de dispositifs à semi-conducteur, le circuit comprenant en outre des moyens de commutation agencés pour déconnecter la grille du dispositif à semi-conducteur défaillant de l'unité à grilles, lesdits moyens de commutation étant agencés en outre pour déconnecter ladite grille du dispositif à semi-conducteur défaillant avant la délivrance de l'impulsion à haute tension.

5. Circuit selon la revendication 3, dans lequel l'unité à haute tension est agencée au niveau de l'unité à grilles.

6. Circuit selon la revendication 4, dans lequel les moyens de commutation sont agencés au niveau de l'unité à grilles.

7. Circuit selon la revendication 1, dans lequel l'unité à haute tension est agencée pour délivrer des impulsions à haute tension séquentiellement, une à la fois, aux grilles des autres dispositifs à semi-conducteur.

8. Circuit selon l'une quelconque des revendications 1 à 7, comprenant une pluralité de modules à semi-conducteur de puissance (30¹-310^{N}) montés en série.

9. Procédé d'un module à semi-conducteur de puissance (100 ; 200) comprenant :
une pluralité de dispositifs à semi-conducteur (110, 120 ; 211-216), chaque dispositif à semi-conducteur comprenant une puce à semi-conducteur (111) dotée d'un collecteur, d'un émetteur et d'une grille (116, 126 ; 220) et étant agencé pour passer dans un mode défaillance court-circuit, noté SCFM, en cas de défaillance du dispositif à semi-conducteur,
une borne collecteur (114) étant agencée pour connecter collectivement les collecteurs de la pluralité de dispositifs à semi-conducteur à des composants de circuit externes, et
une borne émetteur (115) étant agencée pour connecter collectivement les émetteurs de la pluralité de dispositifs à semi-conducteur à des composants de circuit externes,
le procédé comprend la détection du passage de l'un quelconque des dispositifs à semi-conducteur dans le SCFM, et la délivrance d'une impulsion à haute tension à la grille d'au moins un des autres dispositifs à semi-conducteur (212-216) de la pluralité de dispositifs à semi-conducteur,
ladite impulsion à haute tension étant délivrée en réponse au passage d'un dispositif à semi-conducteur défaillant (211) de la pluralité de dispositifs à semi-conducteur dans un SCFM,
**caractérisé en ce que** ladite impulsion à haute tension est établie de manière à faire circuler un courant excessif dans la puce à semi-conducteur (111) de l'au moins un des autres dispositifs à semi-conducteur (212-216) pour provoquer le passage du dispositif dans le SCFM.

10. Procédé selon la revendication 9, comprenant en outre la déconnexion de la grille du dispositif à semi-conducteur défaillant d'une unité à grilles (230) avant la délivrance de l'impulsion à haute tension.

11. Procédé selon la revendication 9, comprenant en outre la délivrance séquentielle d'impulsions à haute tension, une à la fois, aux grilles des autres dispositifs à semi-conducteur.
